# EUROPÄISCHE PATENTSCHRIFT

(11) **EP 0 755 176 B1**
(45) Veröffentlichungstag und Bekanntmachung des Hinweises auf die Patenterteilung: **15.09.2004**
(21) Anmeldenummer: 96110145.8
(22) Anmeldetag: 24.06.1996
(51) Int. Cl.: H05K 7/14, G02B 6/42

(54) **Vorrichtung zur Herstellung einer elektrischen und/oder optischen Verbindung**
Device for establishing an electrical and/or optical connection
Dispositif pour l'etablissement d'une connexion électrique ou optique, ou les deux

(30) Priorität: 19.07.1995 DE 19526330
(43) Veröffentlichungstag der Anmeldung: 22.01.1997
(73) Patentinhaber: International Business Machines Corporation, Armonk, N.Y. 10504 (US)
(72) Erfinder: Eberhardt, Regina, 75365 Calw (DE); Notter, Frank, Dipl.-Ing., 71154 Nufringen (DE); Recktenwald, Willi, Dipl.-Ing., 71088 Holzgerlingen (DE); Renner, Andreas, Dipl.-Ing., 72108 Rottenburg (DE)
(74) Vertreter: Klein, Hans-Jörg

(56) Entgegenhaltungen:
- EP-A- 0 317 467
- DE-U- 6 610 341
- DE-U- 8 402 748

## Beschreibung

Die Erfindung betrifft eine Vorrichtung zur Herstellung einer elektrischen und/oder optischen Verbindung.

An elektrische und/oder optische Verbindungen, insbesondere Steckverbindungen, werden in der Praxis hohe Anforderungen gestellt, denn sie müssen unter verschiedenen Belastungen, wie z.B. Schwingungen, Temperaturunterschiede usw. gewährleisten, daß die durch die Steckverbindung hergestellten Kontakte nicht gelöst werden. Des weiteren sollen diese Verbindungen bedienungsfreundlich hinsichtlich des Herstellens und des Lösens der Verbindung sein.

Damit eine Steckverbindung diese Anforderungen erfüllen kann, bedarf sie einer Verriegelungsvorrichtung zum Verschieben und Lösen der Teile der Steckverbindung. Durch eine solche Vorrichtung wird sichergestellt, daß alle Kontakte geschlossen werden und zum anderen, daß diese Kontakte sich nicht von selbst während des Betriebes lösen.

In der europäischen Patentanmeldung EP 03 69 025 ist eine Vorrichtung beschrieben, mit der Karten mit der Platine verbunden und wieder gelöst werden können. Die Vorrichtung besteht aus einem elastischen Rastteil, das mit der Karte verbunden ist, wobei das Rastteil ein bewegliches Endteil aufweist und einen Bedienungshebel, der drehbar an der Karte gelagert ist. Bedienungshebel und Rastteil sind so zueinander angeordnet, daß beim Drehen des Bedienungshebels das Rastteil aufgrund der gekrümmten Oberfläche des Bedienungshebels eine translatorische Bewegung ausführt, wodurch eine Verbindung zwischen Karte und Platine hergestellt wird. Ist eine wirksame Verbindung hergestellt, fällt das bewegliche Endteil in eine am Bedienungshebel vorgesehene Nut ein und verharrt in dieser Position, wodurch die Karte in dieser Position fixiert wird. Ein Nachteil dieser Vorrichtung liegt insbesondere darin, daß der durch die Einschubkraft ausgeübte Druck dauernd auf der Platine lastet, so daß die Platine während der Verbindung mit der Karte unter starker Spannung steht. Außerdem läßt es sich nicht ausschließen, daß die Einschubkraft aufgrund der vielen Kontakte, die durch die Steckverbindung hergestellt werden müssen, so groß ist, daß sich die Platine durchbiegt. Eine dauerhafte Durchbiegung der Platine führt aber zu Rissen auf der Platine, so daß die aufgedruckten Leitungen zerstört werden. Ein weiterer Nachteil dieser Vorrichtung ergibt sich daraus, daß aufgrund der vorgenannten Probleme die Anzahl der Kontakte, die durch eine Steckverbidnung hergestellt werden können, begrenzt ist, d.h. daß große Karten mit sehr vielen Kontakten mit dieser Vorrichtung nicht verriegelt werden können. Die Funktionen müssen daher auf mehreren Karten verteilt werden, was zu größeren Gehäusen führt.

Eine Vorrichtung der eingangs genannten Art zum Verriegeln und Lösen einer Verbindung für elektrische Steckkontakte ist in dem IBM Technical Disclosure Bulletin, Vol. 31, No. 11, April 1989, S. 76-80, beschrieben. Diese Vorrichtung besteht aus Rasthebeln, die an der oberen und unteren Ecke der Karte oder des Schutzgehäuses angeordnet sind, und aus Sperren, die am Gehäuse befestigt sind. Jedem Rasthebel ist eine Sperre funktional derart zugeordnet, daß der Rasthebel erst dann in Eingriff mit der Sperre kommen kann, wenn eine wirksame Verbindung zwischen Karte und Platine hergestellt worden ist. Ein wesentlicher Nachteil dieser Vorrichtung besteht darin, daß der Druck, der zum Verbinden der Karte mit der Platine erforderlich ist, während des gesamten Betriebes auf den Teilen der Steckverbindung lastet. Im übrigen weist diese Vorrichtung die gleichen Nachteile auf, die bei der europäischen Anmeldung EP 03 69 025 aufgeführt worden sind.

Aus der US 29 93 187 ist eine Vorrichtung bekannt, bei der Rasthebel an am Gehäuse angebrachten, federnden Bügeln angreifen. Durch diese Anordnung können Kräfte quer zur Einschiebevorrichtung auf die Leiterplatte einwirken.

Aus der DE 4042060 C1 ist eine Vorrichtung zum Verbindung und Lösen einer elektrischen Steckverbindung bekannt. Die Vorrichtung besteht aus Rasthebeln, die drehbar am unteren und oberen Eckbereich eines Schutzgehäuses bzw. einer Karte angeordnet sind, und flexibel ausgestalteten Teilen, insbesondere Federn, die entweder an einem unflexiblen Sperrteil oder direkt am Gehäuse befestigt sind. An den flexiblen Teilen befindet sich ein Mitnehmerteil.

Aus dem deutschen Gebrauchsmuster DE-U-6610341 ist eine steckbare Baugruppeneinheit für Fernmelde-, insbesondere Fernsprechanlagen bekannt, die aus mehreren miteinander mechanisch verbundenen und mit Abstand zueinander parallelen Trägern besteht, die ohne ein äußeres Gehäuse angeordnet sind.

Den vorbekannten Vorrichtungen ist der Nachteil gemeinsam, dass damit nur eine relativ begrenzte Anzahl von Verbindungen herstellbar ist. Insbesondere bei Steckverbindungen tritt nämlich das Problem auf, dass bei einer zunehmenden Anzahl der Kontaktstifte die aufzubringende Einschubkraft wächst. Die Einschubkraft darf jedoch ein zulässiges Höchstmaß nicht überschreiten, um eine Beschädigung der Leiterplatten zu vermeiden und auch, um eine aufwändige mechanische Konstruktion zur Aufbringung der erforderlichen Einschubkraft einzusparen. Beispielsweise ist die maximale Anzahl von Verbindungen, die mit der aus der DE 40 42 060 bekannten Vorrichtung herstellbar sind, 600 Verbindungen für eine Leiterplatte.

Figur 1 zeigt eine solche aus der DE 40 42 060 bekannte Vorrichtung. Wie Figur 1 zeigt, werden eine oder mehrere Karten 3 parallel nebeneinander in ein Gehäuse 1 eingeführt und innerhalb des Gehäuses 1 mit einer Platine 5 verbunden. Die Karten 3, insbesondere wenn es sich um elektronische Karten handelt, werden üblicherweise in einem Schutzgehäuse 6 zum Schutz gegen elektromagnetische Strahlung gelagert. Dieses Schutzgehäuse 6 ist so gestaltet, daß es eine Öffnung aufweist, aus denen ein Kontaktverbindungsteil 4 herausragt, das mit einem Kontaktverbindungsteil 7 der Platine 5 verbunden wird. Am Schutzgehäuse 6 befindet sich an einer Seite in der oberen und unteren Ecke jeweils ein Rasthebel 9, die schwenkbar am Schutzgehäuse 6 gelagert sind. Soweit aus technischen Gründen auf das Schutzgehäuse 6 zur Abschirmung der Karte 3 verzichtet werden kann, ist die Befestigung des Rasthebels 9 direkt an der Karte 3 möglich.

An dem Gehäuse 1 befindet sich jeweils im oberen und unteren Bereich Sperren 11, in die die Rasthebel 9 erst dann eingreifen können, wenn eine wirksame Verbindung zwischen dem Kontaktverbindungsteil 7 der Platine 5 und dem Kontaktverbindungsteil 4 der Karte 3 hergestellt worden ist. Die Sperren 11 können einzeln oder gemeinsam an einem Teil befestigt, am Gehäuse 1 angebracht sein.

Das Kontaktverbindungsteil 4 kann beispielsweise ein sogenannter 600-Pin Konnektor sein. Eine Erhöhung der Anzahl der Pins über 600 hinaus würde eine zu große Steckkraft erforderlich machen, die durch Muskelkraft nicht mehr aufbringbar wäre und außerdem die Karte 3 oder deren Gehäuse 6 beschädigen könnte.

Auf Leiterplatten werden zunehmend hochkomplexe Schaltkreise untergebracht, die eine große Anzahl von Verbindungen zur Kommunikation mit der Umgebung, insbesondere mit anderen Leiterplatten, erfordern.

Der Erfindung liegt daher die Aufgabe zugrunde, eine Vorrichtung zur Herstellung einer elektrischen und/oder optischen Verbindung zu schaffen, die die Herstellung einer größeren Anzahl von Verbindungen ermöglicht.

Das der Erfindung zugrundeliegende Problem wird durch die Merkmale des unabhängigen Ansprüchs 1 gelöst.

Die Anzahl der Verbindungen, die sich zwischen zwei Bauelementen - z.B. zwischen einer Karte 3 und einer Platine 5 - herstellen lassen, ist begrenzt. Erfordert die Komplexität eines ersten Bauelements, das mit einem weiteren Bauelement verbunden werden soll, etwa aufgrund der Komplexität der in dem ersten Bauelement realisierten Schaltkreise, eine größere Anzahl von Verbindungen, als sie mit einer herkömmlichen Vorrichtung herstellbar sind, beschreitet die Erfindung den folgenden Weg: Anstelle eines einzigen ersten Bauelements wird dessen Funktionalität durch zwei Bauelemente realisiert, d.h. konstruktiv auf zwei Bauelemente aufgeteilt. Das kann etwa dadurch erreicht werden, daß ein erster Teil der hochkomplexen Schaltkreise auf dem ersten Bauelement und ein zweiter Teil der hochkomplexen Schaltkreise auf dem zweiten Bauelement realisiert ist. Das erste und das zweite Bauelement können dann beispielsweise als Leiterplatten ausgebildet sein. Um die erforderliche Funktionalität insgesamt herzustellen müssen das erste und das zweite Bauelement miteinander verbunden sein. Die hierfür vorgesehen Verbindungsmittel lassen ein mechanisches Spiel zwischen den beiden Bauelementen zu. Beide Bauelemente haben ein Verbindungsteil, z.B. einen 600-Pin Konnektor, zur Verbindung mit dem dritten Bauelement, beispielsweise mit der Platine 5.

Aufgrund des mechanischen Spiels zwischen dem ersten und dem zweiten Bauelement ist es nun möglich, die beiden Bauelemente, obschon sie funktionell eine Einheit bilden, getrennt voneinander mit dem dritten Bauelement zu verbinden, also etwa in die Platine 5 einzustecken. Das hat den Vorteil, daß zweimal hintereinander eine Einschubkraft aufgewendet wird, die ein vorgegebenes Maximum nicht überschreitet.

Die Verbindungsmittel zur elektrischen und/oder optischen Verbindung des ersten und des zweiten Bauteils miteinander können flexibel sein. Hierzu eignen sich flexible Leiter oder flexible Leiterfolien, die aus einer Mehrzahl von Leitern bestehen. Solche Leiterfolien sind ansich aus dem Stand der Technik bekannt.

Damit der Zusammenhalt zwischen dem ersten und dem zweiten Bauelement gewährleistet ist, weist die erfindungsgemäße Vorrichtung ferner eine Vorrichtung zur Begrenzung des mechanischen Spiels zwischen dem ersten und dem zweiten Bauteil auf.

Die Vorrichtung zur Begrenzung des mechanischen Spiels kann ein erstes und ein zweites Verbindungselement aufweisen, die ineinander eingreifen und zueinander verschiebbar sind. Anschlagelemente begrenzen die Verschiebbarkeit in zwei Richtungen. Vorzugsweise ist dabei die Verschiebbarkeit des ersten und zweiten Bauelements zueinander in einer Richtung ermöglicht, die im wesentlichen der Einschubrichtung der Bauelemente in das dritte Bauelement, etwa die Platine 5, entspricht.

Die Vorrichtung zur Begrenzung des mechanischen Spiels kann auch mit Hilfe der Gehäuse des ersten und des zweiten Bauelements realisiert sein. Eines der beiden Verbindungselemente kann mit einem der Gehäuse fest verbunden sein, während das andere Verbindungselement als Ausnehmung in dem anderen Gehäuse ausgebildet ist.

Ebenso kann eines oder mehrere der Anschlagelemente, die das mechanische Spiel begrenzen mittels der Gehäuse realisiert sein. Ein erstes Anschlagselement kann dabei fest mit einem der Gehäuse verbunden sein und in eine Ausnehmung des anderen Gehäuses hineinragen. Ein zweites Anschlagelement kann dann an einer Kante des ersten Verbindungselements ausgebildet sein, beispielsweise an eine Begrenzung der Ausnehmung in Richtung der Einschubbewegung. Dadurch werden in Vorwärts- und Rückwärtsrichtung Anschläge gebildet, die - vorausgesetzt, daß die Vorrichtung zur Begrenzung des mechanischen Spiels nur ein Spiel der ersten und zweiten Bauelemente im wesentlichen in der Einschubrichtung zuläßt - das Spiel zwischen den Bauelementen wirksam begrenzt und so eine Beschädigung der Verbindungsmittel vermieden wird. Dies ist insbesondere bei flexiblen Leiterfolien, die aus bis zu 600 Leitern bestehen können, von großer Wichtigkeit.

Um eine problemlose Einschubbewegung des ersten und des zweiten Bauelements zu gewährleisten, können Führungselemente an zumindest einem der Gehäuse ausgebildet sein, die zur Führung der Relativbewegung zwischen dem ersten und dem zweiten Bauelement dienen. Dadurch wird insbesondere verhindert, daß sich das erste und das zweite Bauelement bei einer Relativbewegung verkanten. Außerdem können z.B. die Gehäuseoberkanten des ersten und des zweiten Bauelements schienenförmig ausgebildet sein, um die Einschubbewegung zu erleichtern. Dies ist ansich bekannt, insbesondere aus der DE 40 42 060.

Eine Mehrzahl von Einschüben, die aus mindestens einem ersten und einem zweiten Bauelement bestehen und eine erfindunggemäße Vorrichtung aufweisen, können in ein gemeinsames drittes Bauelement, etwa einer Platine 5 eingesteckt werden. Dadurch kann in einem Gehäuse 1 eine funktionelle Einheit eines Computersystems gebildet werden.

Die Erfindung ist nicht darauf beschränkt, daß eine Verbindung zwischen einem ersten und einem zweiten Bauelement mit einem dritten Bauelement hergestellt wird, sondern die Lehre der Erfindung ist auch anwendbar auf die Verbindung von mehr als zwei Bauelementen untereinander und mit einem gemeinsamen weiteren Bauelement, wie etwa einer Platine 5. Dann können die Verbindungsmittel diese Bauteile untereinander verbinden und ebenso die Vorrichtung zur Begrenzung des mechanischen Spiels das Spiel dieser Bauelemente untereinander begrenzen. Dadurch ist es möglich diese Bauelemente, obschon sie eine bauliche und funktionelle Einheit bilden, jeweils separat mit dem weiteren Bauelement zu verbinden.

Ein Ausführungsbeispiel der Erfindung ist in der Zeichnung dargestellt und wird im folgenden näher beschrieben.

Es zeigen
- Figur 1: eine perspektivische Ansicht einer Karte und eines Gehäuses zur Aufnahme mehrerer solcher Karten nach dem Stand der Technik,
- Figur 2: eine perspektivische Ansicht einer erfindungsgemäßen Vorrichtung, wobei das erste und das zweite Bauelement von jeweils einem Gehäuse umgeben ist,
- Figur 3: eine perspektivische Teilansicht der in Figur 2 dargestellten Vorrichtung,
- Figur 4: eine Explosionsdarstellung in perspektivischer Ansicht des ersten Bauelements und der dazugehörigen Vorrichtungsteile der Figur 2, und
- Figur 5: eine Explosionsdarstellung in perspektivischer Ansicht des zweiten Bauelements und der dazugehörigen Gehäuseteile der Figur 2.

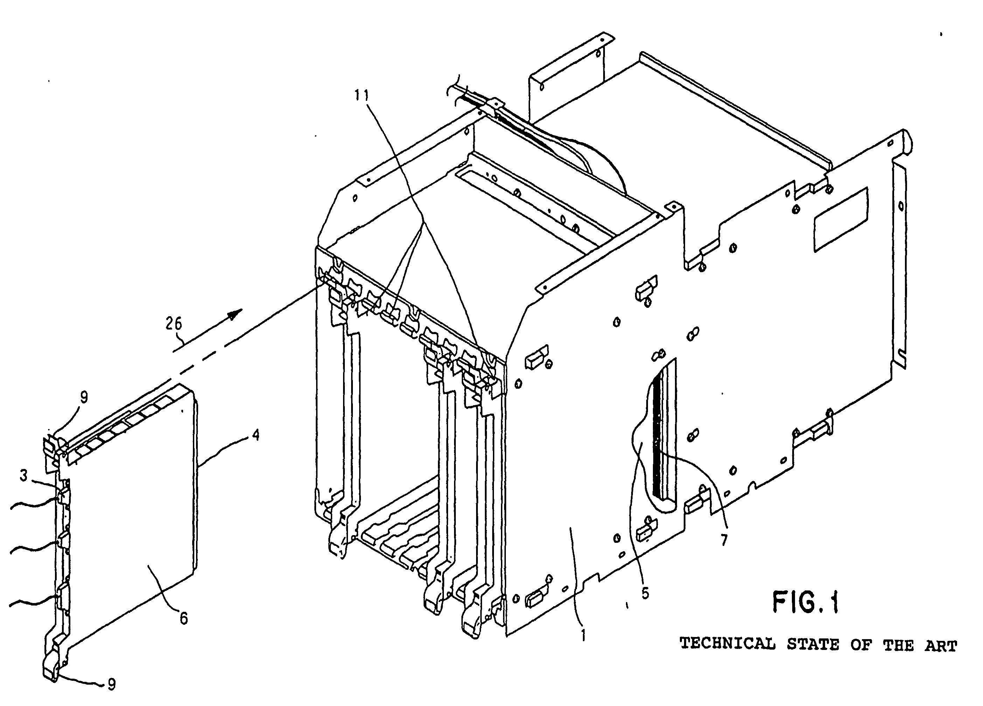

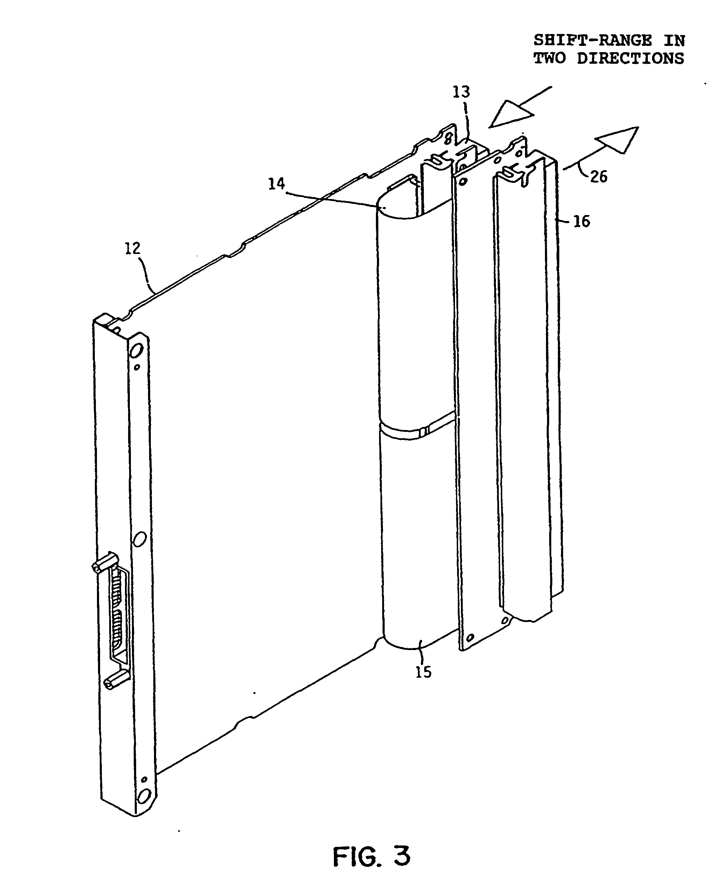

Figur 3 zeigt das erste Bauelement 12, welches in diesem Ausführungsbeispiel als Leiterplatte ausgebildet ist. Das erste Bauelement weist ein Verbindungsteil 13 auf. Das Verbindungsteil 13 ist ein 600-Pin-Konnektor zur Herstellung von 600 Verbindungen mit der in Figur 1 gezeigten Platine 5. Das Verbindungsteil 13 ist fest an dem ersten Bauelement 12 angebracht. Das Verbindungsteil 13 ist über zwei flexible Folien 14 und 15 mit einem Verbindungsteil 16 elektrisch verbunden. Die Folien 14 und 15 beinhalten eine Vielzahl von Kupferleitungen.

Das Verbindungsteil 16 gehört zu dem zweiten Bauelement, welches nicht in der Figur 3 gezeigt ist. Durch die Verbindung der Verbindungsteile 13 und 16 über die flexiblen Leiterfolien 14 und 15 sind das erste und das zweite Bauelement miteinander verbunden. Aufgrund der Flexibilität der Leiterfolien besteht ein mechanisches Spiel zwischen dem ersten und dem zweiten Bauelement.

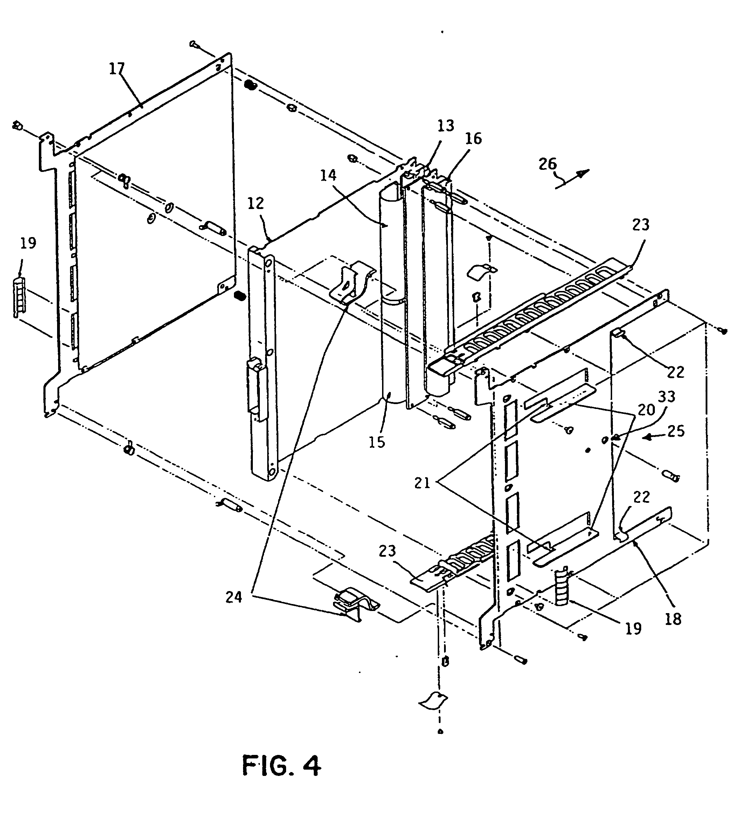

Figur 4 zeigt die Gehäuseteile 17 und 18 des Gehäuses des ersten Bauelements 12. Das Gehäuse des ersten Bauelements 12 dient auch zur elektromagnetischen Abschirmung. Die Federn 19, die an den Gehäuseteilen 17 und 18 angebracht sind, dienen zur Herstellung elektrischer Kontakte mit benachbarten Gehäusen anderer Bauelemente, sobald die Bauelemente wie in Figur 1 gezeigt, nebeneinander eingesteckt sind. Auch dies dient zur Schirmung der jeweiligen Bauelemente.

An dem Gehäuseteil 18 sind zwei erste Verbindungselemente 20 fest angebracht. Jedes der ersten Verbindungselemente 20 hat eine Ausnehmung in Richtung 26 der Einschubbewegung. Durch die Ausnehmungen werden Anschlagelemente 21 an einer Kante der Ausnehmung gebildet. An dem Gehäuseteil 18 sind ferner Führungselemente 22 befestigt.

Das Gehäuseteil 18 hat eine rechteck-förmige Ausnehmung 25. Die kürzeren Kanten der rechteck-förmigen Ausnehmung 25 weisen in Richtung der Einschubbewegung 26. Die oberen und unteren Begrenzungen des Gehäuses des ersten Bauelements, d.h. die Ober- und Unterteile des Gehäuses, sind als schienenförmige Elemente 23 ausgebildet. An den Gehäuseober- und unterkanten befinden sich jeweils Rasthebel 24, die den aus dem Stand der Technik bekannten Rasthebeln 9 (vgl. Figur 1) entsprechen.

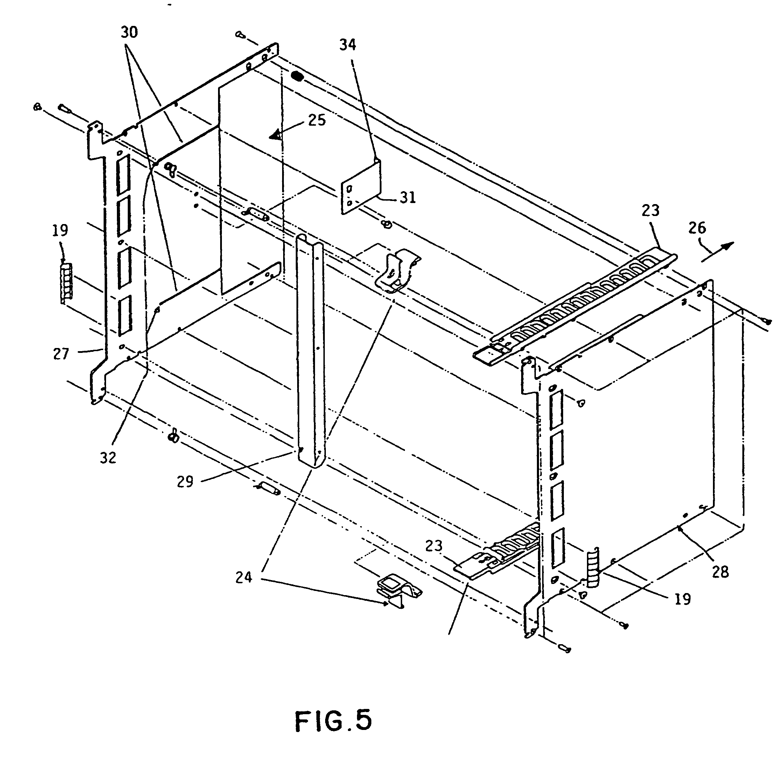

Figur 5 zeigt das Gehäuse des zweiten Bauelements. Das zweite Bauelement kann ebenfalls eine Leiterplatte sein. Das zweite Bauelement, das in Figur 5 nicht gezeigt ist, wird durch das Abschlußteil 29 gehalten. Das Gehäuse des zweiten Bauelements besteht ferner aus den Gehäuseteilen 27 und 28 sowie aus den beiden weiteren schienenförmigen Elementen 23 zur Begrenzung des Gehäuses nach oben und unten.

Das Gehäuseteil 27 weist ebenso wie das Gehäuseteil 18 des ersten Bauelements eine rechteck-förmige Ausnehmung 25 auf. Im zusammengebauten Zustand die Gehäuseteile 18 des ersten Bauelements und das Gehäuseteil 27 des Gehäuses für das zweite Bauelement unmittelbar benachbart angeordnet und über die Federn 19 miteinander in Kontakt. Das Gehäuseteil 27 weist zwei schlitzförmige Ausnehmungen 30 auf, die sich in Richtung der Schubbewegung 26 erstrecken. Die Ausnehmungen 30 dienen zur Aufnahme der ersten Verbindungselemente 20. Die Verbindungslemente 20 greifen jeweils mit deren Ausnehmung in die Ausnehmungen 30 in dem Gehäuseteil 27 ein. Durch die Ausnehmungen 30 ist deshalb in dem Gehäuseteil 27 ein zweites Verbindungselement realisiert.

An dem Gehäuseteil 27 ist ferner ein winkelförmiges Anschlagelement 31 fest angebracht. Das Anschlagelement 31, d.h. dessen winkelförmiger Vorsprung ragt durch die Ausnehmung 25 des Gehäuseteils 27 in die Ausnehmung 25 des Gehäuseteils 18.

Dadurch, daß die Verbindungselemente 20 mit deren Ausnehmungen in die Ausnehmungen 30 in dem Gehäuseteil 27 eingreifen, ist ein Spiel des ersten und des zweiten Bauelements zueinander im wesentlichen in Richtung der Einschubbewegung 26 gewährleistet. Dieses Spiel wird zum einen dadurch begrenzt, daß die ersten Verbindungselemente 20 mit deren Anschlagelemente 21 die hintere Begrenzung 32 der Ausnehmungen 30 in den Gehäuseteil 27 erreichen.

Zum anderen wird das Spiel in der entgegengesetzten Richtung durch das Anschlagelement 31 begrenzt, nämlich dann, wenn der winkelförmige Vorsprung des Anschlagselement 31 in dem Bereich 33 der durch die Ausnehmung 25 an dem Gehäuseteil 18 gebildeten Gehäusekante anschlägt. Der winkelförmige Vorsprung des Anschlagelement 31 berührt dann in einem Bereich 34 dieses winkelförmigen Vorsprungs den Bereich 33 des Gehäuseteils 18.

Dadurch ist einerseits sichergestellt, daß ein ausreichendes mechanisches Spiel zwischen den beiden Gehäusen besteht und außerdem, daß die Gehäuse zusammengehalten werden und mechanisch eine Einheit bilden. Das mechanische Spiel ist dabei gerade so groß, daß eine Beschädigung der flexiblen Folien 14 und 15 vermieden wird.

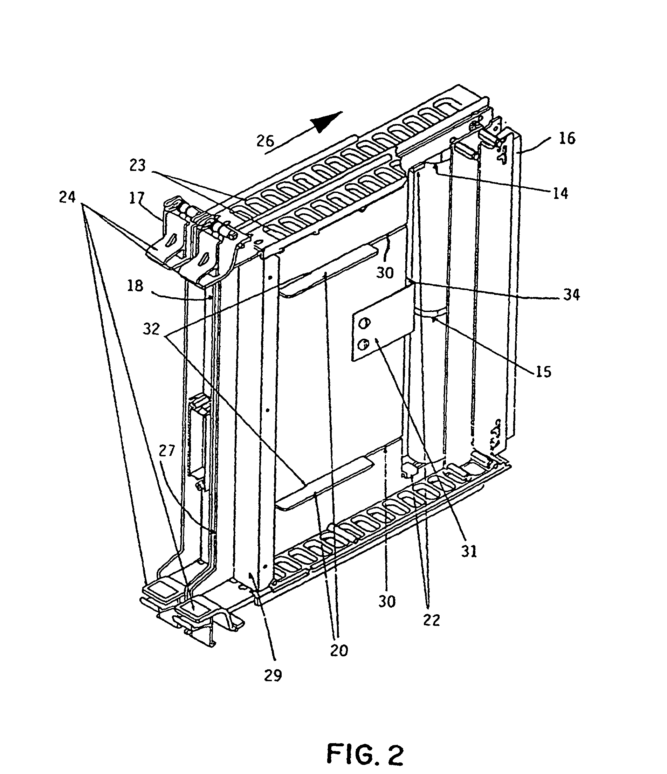

Figur 2 zeigt die Gehäuse der Figuren 4 und 5 in zusammengebautem Zustand. Lediglich der Gehäuseteil 28 und das zweite Bauelement sind in Figur 2 nicht dargestellt, um das Zusammenwirken der Verbindungselemente 20 und 30 sowie das der Anschlagselemente 31, 34 mit der entsprechenden Ausnehmung 25 des Gehäuseteils 18 darzustellen.

Ferner ist in Figur 2 auch der Eingriff der Führungselemente 22 in die Ausnehmung 25 des Gehäuseteils 27 gezeigt. Der in Figur 2 gezeigte Einschub kann nun in ein vorbekanntes Gehäuse 1 zusammen mit anderen vorbekannten Karten 3 untergebracht werden. Dies ist ein besonderer Vorteil des erfindungsgemäßen Einschub, da er kompatibel zu aus dem Stand der Technik bekannten Einschüben ist. Bei Einführung des in Figur 2 gezeigten Einschub in das Gehäuse 1 sind hierfür zwei nebeneinander befindliche freie Steckplätze auf der Platine 5 erforderlich. Aufgrund des mechanischen Spiels zwischen den beiden Bauelementen ist es möglich, zuerst eines der beiden Bauelemente mittels der Rasthebel 9 mit der Platine 5 zu verbinden und unabhängig davon darauffolgend das verbliebene Bauelement ebenfalls auf die gleiche Weise mit der Platine 5 zu verbinden. Dabei kommt es zu einer Relativbewegung der beiden Bauelemente zueinander, die durch die Verbindungselemente und die Vorrichtung zur Begrenzung des mechanischen Spiels ermöglicht ist.

## Patentansprüche

1. Vorrichtung zur Herstellung einer elektrischen und/oder optischen Verbindung einer ersten, in einem ersten Gehäuseteil (17, 18) befindlichen Leiterplatte und einer zweiten, in einem zweiten Gehäuseteil (27, 28) befindlichen Leiterplatte mit einer Platine, mit mindestens einer flexiblen Leiterfolie (14, 15) zur elektrischen und/oder optischen Verbindung der ersten und der zweiten Leiterplatte zur Bildung einer funktionellen Einheit der beiden Leiterplatten, wobei die mindestens eine flexible Leiterfolie (14, 15) in Einschubrichtung (26) der Leiterplatten in das Gehäuse ein mechanisches Spiel zwischen der ersten und der zweiten Leiterplatte zulässt, mit je einem Konnektor (13, 16) für die erste und die zweite Leiterplatte zur elektrischen und/oder optischen Verbindung der ersten und der zweiten Leiterplatte mit der Platine, und mit einer Vorrichtung zur Begrenzung des mechanischen Spiels (20, 21, 30, 31, 32, 34) in Einschubrichtung zwischen der ersten und der zweiten Leiterplatte, wobei die Vorrichtung zur Begrenzung des mechanischen Spiels ein erstes von dem ersten Gehäuseteil (17, 18) vorspringendes und ein zweites, in dem zweiten Gehäuseteil (27, 28) eine schlitzförmige Ausnehmung aufweisendes Verbindungselement (20; 30) enthält, wobei die Verbindungselemente ineinander eingreifen und zueinander verschiebbar sind, und ein oder mehrere Anschlagelemente (21; 32, 33, 34) die Verschiebbarkeit begrenzen.

2. Vorrichtung nach Anspruch 1, wobei die Konnektoren (13, 16) jeweils aus einer Kontaktleiste bestehen, die vorzugsweise bis zu 600 Verbindungen pro Leiterplatte ermöglicht, und die Kontakte vorzugsweise als Kontaktstifte ausgebildet sind.

3. Vorrichtung nach Anspruch 1 oder 2, wobei die Gehäuseteile (17, 18; 27, 28) vorzugsweise auch zur elektromagnetischen Abschirmung der ersten und der zweiten Leiterplatte dienen.

4. Vorrichtung nach einem der Ansprüche 1 bis 3, wobei ein erstes Anschlagelement (31) als winkelförmiges, vorzugsweise rechtwinkliges oder hakenförmiges Element ausgebildet ist und das erste Anschlagelement fest mit einem der Gehäuseteile (17, 18; 27, 28) verbunden ist.

5. Vorrichtung nach Anspruch 4, wobei das erste Anschlagelement in eine Ausnehmung (25) eines der Gehäuseteile ragt und wobei vorzugsweise ein zweites Anschlagelement (21) an einer Kante des ersten Verbindungselements (20) ausgebildet ist.

6. Vorrichtung nach einem der Ansprüche 3 bis 5, mit Führungselementen (22) zur Führung des ersten und zweiten Gehäuseteils (17, 18; 27, 28) zueinander, während der Einschubbewegung (26).

7. Vorrichtung nach Anspruch 6, wobei die Führungselemente (22) winkel- oder hakenförmig ausgebildet sind, mit einem der Gehäuseteile (17, 18; 27, 28) fest verbunden sind und in eine Ausnehmung (25) in dem anderen der Gehäuseteile eingreifen, wobei sich die Ausnehmung (25) in dem anderen der Gehäuseteile in Richtung der Einschubbewegung (26) erstreckt.

8. Vorrichtung nach einem der Ansprüche 5, 6 oder 7, wobei die Ausnehmung (25) in dem Gehäuseteil im wesentlichen rechteckig ist und die kürzere Seite der Ausnehmung (25) in Richtung der Einschubbewegung (26) weist und wobei vorzugsweise durch die längere Seite der Ausnehmung (25) in einem Bereich (33) ein Anschlagelement für ein erstes Anschlagelement (31, 34) gebildet ist.

9. Vorrichtung nach einem oder mehreren der Ansprüche 3 bis 8, wobei eine Begrenzung (23) des ersten und zweiten Gehäuseteils (17,18; 27, 28) in Richtung einer Einschubbewegung der ersten und zweiten Leiterplatte, zur Herstellung der Verbindung, schienenförmig ausgebildet ist.

10. Vorrichtung nach einem oder mehreren der Ansprüche 1 bis 9, wobei die Anschlagelemente die Verschiebbarkeit so begrenzen, dass zunächst die erste oder die zweite Leiterplatte mit der Platine verbunden werden kann.

## Claims

1. A device for establishing an electrical and/or optical connection between a first circuit board positioned in a first housing part (17,18) and a second circuit board positioned in a second housing part (27,28) to a backplane, with at least one flexible conductor foil (14,15) for electrical and/or optical connection of the first and second circuit boards to form a functional unit from the two circuit boards, wherein the at least one flexible conductor foil (14,15) allows mechanical free play between the first and second circuit boards in the direction of insertion (26) of the circuit boards into the housing, with one connector each (13,16) for the first and second circuit boards for electrical and/or optical connection of the first and second circuit boards to the backplane, and with a device for limiting mechanical free play (20, 21, 30, 31, 32, 34), in the direction of insertion, between the first and second circuit boards, wherein the device for limiting mechanical free play contains a first connection element (20) projecting from the first housing part (17, 18) and a second connection element (30) having a slot-shaped recess in the second housing part (27, 28), wherein the connection elements engage with each other and are slidable relative to each other, and one or more stop elements (21; 32, 33, 34) restrict this slidability.

2. Device according to Claim 1, wherein each of the connectors (13,16) consists of a contact strip that preferably allows up to 600 connections per circuit board, and the contacts are preferably in the form of contact pins.

3. Device according to Claim 1 or 2, wherein the housing parts (17, 18; 27, 28) preferably serve also for electromagnetic shielding of the first and second circuit boards.

4. Device according to one of Claims 1 to 3, wherein a first stop element (31) takes the form of an angled, preferably rectangular or hooked, element and the first stop element is affixed to one of the housing parts (17, 18; 27, 28).

5. Device according to Claim 4, wherein the first stop element projects into a recess (25) in one of the housing parts, and wherein preferably a second stop element (21) is provided at one edge of the first connection element (20).

6. Device according to one of Claims 3 to 5, with guide elements (22) for guiding of the first and second housing parts (17, 18; 27, 28) toward each other during the insertion movement (26).

7. Device according to Claim 6, wherein the guide elements (22) are angled or hooked, are affixed to one of the housing parts (17, 18; 27, 28), and engage with a recess (25) in the other housing part, the recess (25) in the other housing part extending in the direction of the insertion movement (26).

8. Device according to one of Claims 5, 6 or 7, wherein the recess (25) in the housing part is essentially rectangular and the shorter side of the recess (25) lies in the direction of the insertion movement (26), and wherein preferably a stop element for a first stop element (31, 34) is formed by the longer side of the recess (25) in an area (33).

9. Device according to one or more of Claims 3 to 8, wherein a boundary (23) of the first and second housing parts (17, 18; 27, 28) is provided in the form of rails, in the direction of the insertion movement of the first and second circuit boards, to establish the connection.

10. Device according to one or more of Claims 1 to 9, wherein the stop elements restrict the slidability in such a way that either the first or second circuit board can be connected to the backplane first.

## Revendications

1. Dispositif d'établissement d'une liaison électrique et/ou optique d'une première plaque à circuit imprimé se trouvant dans une première partie de boîtier (17, 18) et d'une deuxième plaque à circuit imprimé se trouvant dans une deuxième partie de boîtier (27, 28), avec une platine, comprenant au moins une première feuille conductrice (14, 15) flexible pour assurer la liaison électrique et/ou optique de la première et de la deuxième plaques à circuit imprimé, pour former une unité fonctionnelle des deux plaques à circuit imprimé, sachant que la au moins une feuille conductrice (14, 15) flexible permet, dans la direction d'insertion (26) des plaques à circuit imprimé dans le boîtier, d'avoir un jeu mécanique entre la première et la deuxième plaques à circuit imprimé, avec chaque fois un connecteur (13, 16) pour la première et la deuxième plaques à circuit imprimé, pour assurer la liaison électrique et/ou optique de la première et de la deuxième plaques à circuit imprimé à la platine, et avec un dispositif pour limiter le jeu mécanique (20, 21, 30, 31, 32, 34) dans la direction d'insertion, entre la première et la deuxième plaques à circuit imprimé, sachant que le dispositif de limitation du jeu mécanique contient un premier élément de liaison (20; 30) en saillie depuis la première partie de boîtier (17, 18) et un deuxième élément de liaison présentant un évidement en forme de fente dans la deuxième partie de boîtier (27, 28), les éléments de liaison s'engageant l'un dans l'autre et étant déplaçables l'un par rapport à l'autre, et un ou plusieurs éléments de butée (21; 32, 33, 34) délimitent la mobilité en coulissement.

2. Dispositif selon la revendication 1, les connecteurs (13, 16) étant chacun formés d'une bande de contact, permettant de préférence jusqu'à 600 liaisons par plaque à circuit imprimé, et les contacts étant réalisés de préférence sous la forme de broches de contact.

3. Dispositif selon la revendication 1 ou 2, sachant que les parties de boîtier (17, 18; 27, 28) servent de préférence également au blindage ou à l'écrantage électromagnétique de la première et de la deuxième plaques à circuit imprimé.

4. Dispositif selon l'une des revendications 1 à 3, un premier élément de butée (31) est réalisé sous la forme d'élément en forme de cornière, de préférence à angle droit ou en forme de crochet et le premier élément de butée étant relié rigidement à l'une des parties de boîtier (17, 18; 27, 28).

5. Dispositif selon la revendication 14, le premier élément de butée pénétrant dans un évidement (25) d'une des parties de boîtier et, de préférence, un deuxième élément de butée (21) étant réalisé sur une arête du premier élément de liaison (20).

6. Dispositif selon l'une des revendications 3 à 5, avec des éléments de guidage (22) pour assurer le guidage de la première et de la deuxième partie de boîtier (17, 18; 27, 28) l'une par rapport à l'autre pendant le déplacement d'insertion par coulissement (26).

7. Dispositif selon la revendication 6, les éléments de guidage (22) étant réalisés sous forme de cornières ou de crochets, en étant reliés rigidement à l'une des parties de boîtier (17, 18; 27, 28) et s'engageant dans un évidement (25) ménagé dans l'autre des parties de boîtier, sachant que l'évidement (25) s'étend dans l'autre des parties de boîtier, dans la direction du déplacement d'insertion par coulissement (26).

8. Dispositif selon l'une des revendications 5, 6 ou 7, l'évidement (25) ménagé dans la partie de boîtier étant sensiblement rectangulaire et le côté court de l'évidement (25) étant tourné dans la direction du déplacement d'insertion (26) et, de préférence, au moyen du côté long de l'évidement (25), dans une zone (33), est formé un élément de butée pour un premier élément de butée (31, 34).

9. Dispositif selon l'une ou plusieurs des revendications 3 à 8, une limitation (23) de la première et de la deuxième parties de boîtier (17, 18; 27, 28), dans la direction d'un déplacement d'insertion de la première et de la deuxième plaques à circuit imprimé, effectué pour assurer l'établissement de la liaison, étant réalisée en forme de glissière ou de rail.

10. Dispositif selon l'une ou plusieurs des revendications 1 à 9, les éléments de butée limitant la mobilité en coulissement de manière que, d'abord, la première ou la deuxième plaque à circuit imprimé puisse être reliée à la platine.
